(19) Europäisches Patentamt

European Patent Office

Office européen des brevets

(11) **EP 1 102 396 A2**

(12) **EUROPÄISCHE PATENTANMELDUNG**

(43) Veröffentlichungstag:
**23.05.2001 Patentblatt 2001/21**

(51) Int Cl.⁷: **H03H 17/02**

(21) Anmeldenummer: **00124267.6**

(22) Anmeldetag: **13.11.2000**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **19.11.1999 DE 19955665**

(71) Anmelder: **Astrium GmbH**
**81663 München (DE)**

(72) Erfinder: **Craubner, Siegfried**
**82234 Wessling (DE)**

(54) **Filterbank-Anordnung mit Analysebank und Synthesebank, insbesondere für optische Abtastanordnungen**

(57)    Beschrieben wird eine aliasingfreie Filterbank-Anordnung, beinhaltend eine Analysebank (1) und eine Synthesebank (2), wobei sich der Signalpfad durch die Filterbank im Bereich der Analysebank (1) auf mindestens zwei Zweige (3, 4) aufteilt und im Bereich der Synthesebank (2) die Zweige (3, 4) wieder zusammengeführt werden. Jeder der Zweige (3, 4) weist identische Analysefilter (5) auf und die Synthesebank (2) weist eine Kombiniereinrichtung (6) zur Kombination der Signale der einzelnen Zweige (3, 4) auf.

FIG.1

**Beschreibung**

Die vorliegende Erfindung betrifft eine Filterbank-Anordnung, die eine Analysebank und eine Synthesebank beinhaltet, wobei sich der Signalpfad durch die Filterbank im Bereich der Analysebank auf mindestens zwei Zweige aufteilt und im Bereich der Synthesebank die Zweige wieder zusammengeführt werden. Eine solche Filterbank-Anordnung kann insbesondere auch bei optischen Abtastanordnungen Anwendung finden.

Filterbank-Anordnungen mit einer Analysebank und einer Synthesebank sind aus dem Stand der Technik beispielsweise aus G. Strang, T. Nguyen, "Wavelets and Filterbanks", Wellesley-Cambridge Press, 1996, Seiten 14 bis 21, 130 bis 133 und 299 bis 305 sowie aus P.P. Vaidyanathan, "Multirate Systems and Filter Banks", Prentice Hall, 1993, Seiten 188 bis 199 und 223 bis 254 bekannt. In diesem Stand der Technik sind die Filterbank-Anordnungen stets so aufgebaut, dass sich der Signalpfad auf mindestens zwei Zweige aufteilt, wobei die Zweige im Bereich der Synthesebank wieder zusammengeführt werden. Die einzelnen Zweige weisen dabei unterschiedliche Analysefilter, in der Regel Hochpass- und Tiefpassfilter, auf. Aus diesem Stand der Technik ist außerdem bereits das Problem des Aliasing bekannt, das zu Störungen in den zu verarbeitenden Signalen führt.

Weiterhin sind aus dem Stand der Technik bereits Methoden zur elektronischen Datenerfassung und Datenbearbeitung in optischen Abtastanordnungen aus Gerald C. Holst, "Sampling, Aliasing and Data Fidelity", SPIE Optical Engineering Press, Bellingham, Washington, USA, 1998, Seiten 102 bis 129 bekannt, wobei ebenfalls auf die Problematik des Aliasing eingegangen wird.

In Rachel Alter-Gartenberg, "Multiresolution Imaging: An End-to-End Assessment", Journal of Mathematical Imaging and Vision 8, 1998, Seiten 59 bis 77, ist ein Verfahren zu Unterdrückung von Alias-Spektren in optischen Abtastanordnungen mit Hilfe von signalangepaßten Wiener-Filtern beschrieben. Mit solchen Filtern kann eine Verbesserung der Bildqualität erzielt werden, jedoch ist dieses Verfahren äußerst rechenintensiv und damit aufwendig.

Aus Patent Abstracts of Japan, E897, 28. Feb. 1990, Vol. 14/No. 112: JP 01-311715 ist eine Chirp-Filter mit einer Filterbank-Anordnung bekannt, die eine Analysebank und eine Synthesebank aufweist, wobei in der Analysebank Filterzweige mit Filtern mit identischer Frequenzcharakteristik vorgesehen sind und die Filterzweige Verzögerungseinrichtungen aufweisen.

Aufgabe der vorliegenden Erfindung ist es daher, eine vereinfachte und verbesserte Möglichkeit zur Unterdrückung von Aliasing in Filterbank-Anordnungen sowie speziell in optischen Abtastanordnungen bereit zu stellen.

Diese Aufgabe wird gelöst durch die Merkmale der vorliegenden Patentansprüche 1 und 8.

Erfindungsgemäß ist dabei vorgesehen, dass jeder der Zweige identische Analysefilter aufweist und die Synthesebank eine Kombiniereinrichtung zur Kombination der Signale der einzelnen Zweige aufweist. Nachdem in den einzelnen Zweigen nicht mehr verschiedene Arten von Analysefiltern, sondern lediglich eine Art von Analysefiltern vorgesehen ist, wird die gesamte Anordnung wesentlich vereinfacht. Trotzdem kann gezeigt werden, dass eine solche Anordnung bei einer geeigneten Kombination der Signale der einzelnen Zweige ein Verhalten aufweist, das frei von Aliasing ist. Es wird dabei vorgesehen, dass die Zweige Einrichtungen zum Aufwärtssampling sowie Verzögerungseinrichtungen zur relativen Verzögerung der Signale der einzelnen Zweige untereinander aufweisen. So kann beispielsweise vorgesehen sein, dass jedes Signal eines bestimmten Zweiges um einen bestimmten Betrag gegen den vorherigen, angrenzenden Zweig versetzt ist. Durch eine Kombination einer solchen Verzögerung mit einem Aufwärtssampling , bei dem zwischen bestehende Daten zusätzliche Daten, beispielsweise in Form von Nullen, eingeschoben werden, wird eine spezielle Form der Zusammenfassung der Signale der einzelnen Zweige ermöglicht, in dem die Daten eines ersten Zweiges nach dem Aufwärtssampling an die Stelle der Nullen der Daten eines zweiten Zweiges eingefügt werden.

Zusätzlich kann vorgesehen werden, dass Einrichtungen zum Abwärtssampling in den Zweigen angeordnet sind, wobei die Einrichtungen zum Abwärtssampling den Einrichtung zum Aufwärtssampling vorgeschaltet sind. Man erreicht dadurch zunächst eine Datenreduktion, die die Erhöhung der Datenmenge kompensiert, die durch das Aufwärtssampling bewirkt wird.

Insbesondere kann vorgesehen sein, dass die Analysefilter das Verhalten eines Tiefpass-Filters aufweisen.

Nachdem in der Regel die Analysefilter kein ideales Übertragungsverhalten aufweisen, kann vorgesehen werden, dass jeder der Analysefilter mit einem entsprechenden Inversenfilter kombiniert ist. Durch diese Kombination aus Analysefilter und Inversenfilter kann eine weitgehend ideale Übertragung in der gewünschten Bandbreite erreicht werden. Sofern es sich bei dem Inversenfilter um einen Filter mit einer ansteigenden Charakteristik handelt, kann es unter Umständen zu Instabilitäten des Filters kommen. In solchen Fällen kann vorgesehen werden, dass ein Fensterfilter zur Begrenzung des Inversenfilters vorgesehen ist, um eine Stabilisierung zu erreichen.

Um eine Optimierung und möglichst weitgehende Reduzierung der von den einzelnen Filtern zu bearbeitenden Datenmengen zu erreichen, kann vorgesehen sein, dass die Filterbank-Anordnung als Polyphasen-Anordnung ausgebildet ist. Solche Polyphasen-Anordnungen sind aus dem vorstehend zitierten Stand der Technik bereits bekannt.

Für das spezielle Gebiet der optischen Bilderfassung kann eine optische Abtastanordnung in die Signalverarbeitungsform einer Filterbank-Anordnung gebracht werden, wie sie bereits vorstehend beschrieben wurde. Speziell kann dabei die optische Abtastanordnung mindestens zwei Detektoreinrichtungen aufweisen, wobei jede einzelne Detektoreinrichtung in der Signalverarbeitungskette bereits einen Analysezweig der Filterbank-Anordnung darstellt, d. h. die Analysezweige in Form von Tiefpass-Filtern sind bereits durch die optische Abtastanordnung und speziell dabei durch die Detektoreinrichtungen realisiert. Es ist also jeder Detektoreinrichtung mindestens ein Zweig einer Filterbank-Anordnung zugeordnet und jede Detektoreinrichtung bildet einen Analysezweig der Filterbank-Anordnung. Analog zu den vorstehenden Ausführungen ist vorgesehen, dass die Filterbank-Anordnung eine Synthesebank aufweist, wobei sich der Signalpfad durch die Filterbank auf mindestens zwei Zweige aufteilt und im Bereich der Synthesebank die Zweige wieder zusammengeführt werden. Die Synthesebank weist eine Kombiniereinrichtung zur Kombination der Signale der einzelnen Zweige auf und diese Zweige wiederum weisen Einrichtungen zum Aufwärtssampling sowie Verzögerungseinrichtungen zur relativen Verzögerung der Signale der einzelnen Zweige untereinander auf.

Jede der Detektoreinrichtungen kann beispielsweise zeilenförmig oder matrixförmig ausgebildet sein. In beiden Fällen erfolgt eine 2-dimensionale Abtastung der Objektszene. Bei einer zeilenförmigen Detektoranordnung, bei der sich die Detektorzeile in eine x-Richtung erstreckt und sich die Detektoranordnung in eine dazu orthogonale y-Richtung bewegt, erfolgt diese 2-dimensionale Abtastung räumlich in x-Richtung und zeitlich-räumlich in y-Richung, da sich die zeilenförmige Detektoranordnung in der zur Zeile orthogonalen Richtung bewegt und dabei die Detektorsignalwerte in Zeitinkrementen sukzessive ausgelesen werden. Bei der matrixförmigen Detektoranordnung erfolgt die 2-dimensionale Abtastung direkt und zeitgleich durch die 2-dimensionale Detektoranordnung.

In beiden Fällen ist durch die von der Filterbank-Anordnung vorgegebene Struktur der Signalverarbeitung eine 2-dimensionale digitale Filterung gegeben. Da die 2-dimensionale digitale Filterung in zwei aufeinanderfolgende gleiche 1-dimensionale Filterungen separiert werden kann, genügt hier die Betrachtung des 1-dimensionalen Filterungs-Grundmusters. Allerdings ist eine Realisierung der Filterbank mit 2-dimensionalen digitalen Filterungen gegenüber der zweifach angewandten 1-dimensionalen Filterung mit geringerem elektronischen Aufwand zu realisieren.

Es kann daher entweder ein zeilenförmiges Detektorelement vorgesehen sein oder mehrere Detektorelemente zeilenförmig angeordnet sein, die in ihre Gesamtheit eine Detektoreinrichtung bilden. Werden mehrere solcher zeilenförmigen Detektoreinrichtungen parallel zueinander angeordnet, wobei jedoch die einzelnen Detektoreinrichtungen in einer Raumrichtung gegeneinander versetzt sind, so ergibt sich bereits eine relative Verzögerung der den Detektoreinrichtungen zugeordneten Zweigen automatisch aus dieser Art der Anordnung.

Werden matrixförmige Detektoreinrichtungen verwendet, so kann z.B. die gesamte optische Abtastanordnung durch mehrere matrixförmige Detektoreinrichtungen gebildet werden, die z.B. jeweils eine zugehörige Frontoptik pro Detektormatrix aufweisen. Es kann dann jeder Zeile oder Spalte eines matrixförmigen Detektorelements ein Zweig der Filterbank-Anordnung zugeordnet werden. Die einzelnen matrixförmigen Detektoreinrichtungen können dann in geeigneter weise relativ zueinander angeordnet werden, z.B. ebenfalls in einer Matrixform oder auch in Zeilenform. Die einfachste Form einer matrixförmigen Detektoreinrichtung, um eine 2-dimensionale Analysebank einer 2-dimensionalen aliasingfreien Filterbank aufzubauen, ist die Anordnung zweier Detektor-Matrizen mit einem gegenseitigen Versatz von z.B. je einer halben Pixelbreite in beide Richtungen der Ebene, in der sich die Detektor-Matritzen erstrecken.

Die bereits vorstehend beschriebenen Maßnahmen, ein zum Analysefilter inverses Filter sowie gegebenenfalls ein dieses begrenzendes Fensterfilter vorzusehen, kann auch bei einer optischen Abtastanordnung Anwendung finden, ebenso wie die Ausbildung der Filterbank-Anordnung als Polyphasen-Anordnung.

Ein spezielles Ausführungsbeispiel der vorliegenden Erfindung wird nachfolgend anhand der Fig. 1 bis 10 erläutert.

Es zeigen:

Fig. 1:        Schematische Darstellung des Schaltbildes der Filterbank-Anordnung.

Fig. 2:        Schematisches Schaltbild einer Filterbank-Anordnung als Polyphasen-Anordnung.

Fig. 3         Logarithmische Darstellung des Übertragungsverhaltes eines Tiefpass-Analysefilters.

Fig. 4:        Logarithmische Darstellung eines zum Tiefpassfilter inversen Filters.

Fig. 5:        Logarithmische Darstellung eines Fensterfilters.

Fig. 6:        Logarithmische Darstellung der Kombination des Inversenfilters mit dem Fensterfilter.

Fig. 7:        Ogarithmische Darstellung des Übertragungsverhaltens der Kombination aus Analysefilter, Inversenfilter und Fensterfilter.

Fig. 8:        Schematische Darstellung einer optischen Abtastanordnung mit zwei Detektorzeilen.

Fig. 9:     Darstellung des Übertragungsverhaltens der optischen Abtastan- ordnung.

Fig. 10:     Schematische Darstellung einer optischen Abtastanordnung mit zwei Detektormatrizen.

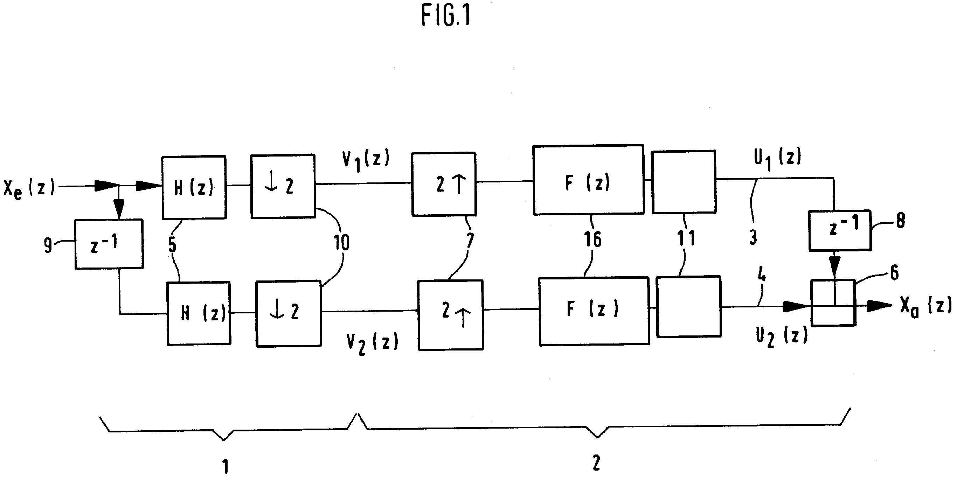

Die erfindungsgemäße Filterbank-Anordnung nach Fig. 1 zeigt eine Analysebank 1 und eine Synthesebank 2 mit zwei Zweigen 3, 4, die fast identisch aufgebaut sind. Jeder der Zweige 3, 4 weist ein Analysefilter 5 auf, der als Tiefpaßfilter ausgebildet ist. Danach folgen Einrichtungen 10 zum zweifachen Abwärtssampling und Einrichtungen 7 zum zweifachen Aufwärtssampling. Nach dem Aufwärtssampling sind in der Regel Synthesefilter 16 als inverse Filter vorgesehen, die bei spezieller Anpassung der Anordnung gegebenenfalls jedoch entfallen können. Jedes Synthesefilter 16 kann, sofern es vorgesehen ist, durch ein zugeordnetes Fensterfilter 11 begrenzt und damit stabilisiert werden. Die beiden Zweige werden in einer Kombiniereinrichtung 6 wieder zusammengeführt. Der zweite Zweig 4 weist bereits in seinem Anfangsbereich eine vom ersten Zweig 3 verschiedene Ausgestaltung auf, in Fig. 1 dargestellt durch eine Verzögerungseinrichtung 9, aus der eine Verzögerung der Signale des zweiten Zweigs 4 gegenüber den Signalen des ersten Zweigs 3 resultiert. Diese Verzögerung kann sich zwangsläufig durch entsprechende bauliche oder elektronische Gegebenheiten der Filterbank-Anordnung ergeben. Um diese Verzögerung wieder auszugleichen, ist im ersten Zweig 3 vor der Kombiniereinrichtung eine entsprechende Verzögerungseinrichtung 9 vorgesehen.
Die Beschreibung der Filterbank-Anordnung kann bevorzugt mit Hilfe der komplexen Z-Transformation erfolgen, so dass in der weiteren Beschreibung auf diese übergegangen werde. Es soll zunächst eine Betrachtung der Filterbank-Anordnung ohne Synthesefilter 16 betrachtet werden.
Definiert ist $z = e^{j\omega}$. Für den Übergang der obigen Gleichungen vom Fourierin den Z-Bereich gelten die folgenden Regeln:

1. Halbierte Frequenzwerte ($\omega/2$) ergeben im Z-Bereich Terme mit $z^{1/2}$,

2. Verdoppelte Frequenzen $2\omega$ ergeben Terme mit $z^2$

3. Um $\pi$ verschobene Frequenzen $\omega$ ergeben Terme mit $(- z)$.

Die Z-Transformierte von $V(\omega) = (\downarrow 2) H(\omega)$ nach dem Abwärtsampling von $H(\omega)$ wird dann:

$$V(z) = (\downarrow 2) H(z) = 1/2 \cdot [ H(z^{1/2}) + H(-z^{1/2})]$$

Ebenso, die Z-Transformierte von $(\uparrow 2) V(z)$ nach dem Aufwärtssampling von $V(Z)$:

$$U(z) = (\uparrow 2) V(z) = V(z^2)$$

Die Operation $U(z) = (\downarrow 2) (\uparrow 2) H(z)$ geht über in:

$$U(z) = 1/2 \cdot [ H(z^2) + H(-z^2)]$$

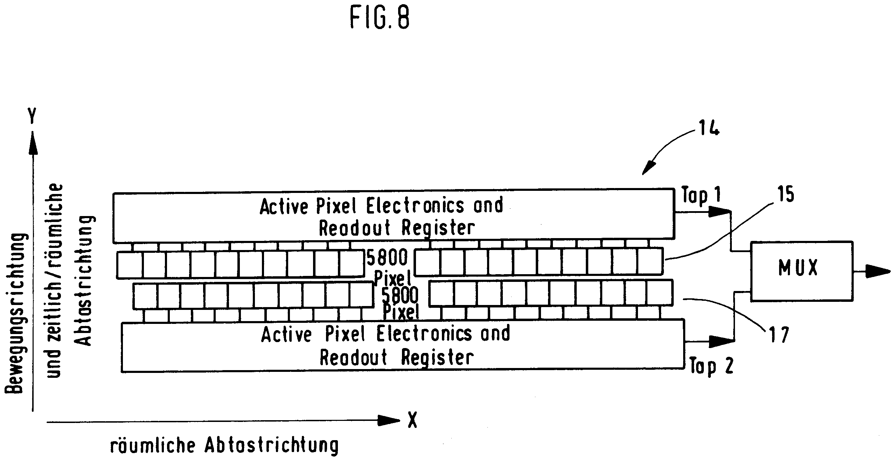

Dabei beschreiben die beiden Zweige 3, 4 bestimmte Signalpfade einer tatsächlichen Umsetzung dieser schematischen Anordnung. Ein solches Beispiel wird nachfolgend unter Bezugnahme auf Fig. 8 erläutert, wobei jeder Zweig 3, 4 dort eine Detektorzeile 15, 17 einer optischen Abtastanordnung 14 beinhaltet. Der Analysefilter 5 des ersten Zweigs 3 gefolgt von dem Abwärtssampler 10 entspricht dem Signalmodell der ersten Detektorzeile 15. Das Ausgangssignal dieser Detektorzeile ist damit:

$$V_1( z) = 1/2 [H(z^{1/2}) + H(-z^{1/2}) ]$$

wobei $H(z^{1/2})$ das Basisband ohne Aliasing und $H(-z^{1/2})$ das Aliasband mit Aliasing-Störungen sind.
Das in den Zweigen 3, 4 vorgesehene zweifache Aufwärtssampling ermöglicht ein bevorzugtes Kombinieren der Signalwerte beider Zweige, bzw. im speziellen Fall der Fig. 8, der beiden Detektorzeilen 15, 17.
Das Aufwärtssampling verändert das Übertragungsspektrum und es ist:

$$U_1(z) = 1/2 \cdot [\, H(z) + H(-z)\,]$$

Es erfolgt eine ausreichende Verzögerung ($z^{-1}$) durch die Verzögerungseinrichtung 8 im ersten Zweig 3, im speziellen Fall nach Fig. 8 z.B. um eine räumliche Abtasteinheit, damit die Signale des ersten Zweigs 3 bzw. der ersten Detektorzeile 15 alternierend mit denen des zweiten Zweigs 4 bzw. der zweiten Detektorzeile 17 kombinieren können. Am Ausgang des ersten Zweigs 3 ist dann

$$z^{-1} \cdot U_1(z) = 1/2 \cdot z^{-1} \cdot [\, H(z) + H(-z)\,]$$

Der zweite Zweig ist, wie bereits beschrieben, im Grunde identisch aufgebaut. Die Verzögerungseinrichtung 9 entspricht im speziellen Fall der Fig. 8 dem räumlich versetzten Aufbau der beiden Detektorzeilen 15, 17. Verzögerungseinrichtung 9 und Analysefilter 5 in Zweig 4 liefern ein Signal $z^{-1} \cdot H(z)$, aus dem sich nach dem Abwärtssampler 10 das Signal

$$V_2(z) = 1/2 \cdot [z^{-1/2}H(z^{1/2}) - z^{-1/2}H(-z^{1/2})] = 1/2 \cdot z^{-1/2}[\, H(z^{1/2}) - H(-z_{1/2})\,]$$

ergibt, das im speziellen Fall dem Ausgangssignal der zweiten Detektorzeile 17 entspricht. Wie in Fig. 8 dargestellt, sind die beiden Detektorzeilen 15, 17 gegeneinander um eine halbe Pixelbreite räumlich versetzt. Daraus ergibt sich eine Verschiebung der Signale der Detektorzeilen 15, 17 mit einem Verzögerungsfaktor $Z^{-1/2}$ im Ausgangssignal der zweiten Detektorzeile 17. Im vorliegenden Fall ergibt sich also die in Fig. 1 in allgemeiner Form eingeführte Verzögerung durch die spezielle bauliche Anordnung in Fig. 8.

Nach Aufwärtssampling ist

$$U_2(z) = 1/2 \cdot z^{-1} [\, H(z) - H(-z)\,]$$

Nach einer Kombination der beiden Signale der Zweige 3, 4 durch die Kombiniereinrichtung 6 erhält man die gesamte Übertragungsfunktion T(z) der Anordnung:

$$T(z) = 1/2 \cdot z^{-1} \cdot [\, H(z) + H(-z) + H(z) - H(-z)\,] = z^{-1} \cdot H(z) \,,$$

Die Aliasing-Komponenten der Signale beider Zweige 3, 4 heben sich gegenseitig auf, da T(z) nur eine Funktion von z, jedoch nicht von -z ist. Mit der erfindungsgemäßen Filterbank-Anordnung kann somit eine aliasingfreie Übertragung erzeugt werden. Da die Alias-Terme wegfallen, ist die nutzbare Übertragungsbandbreite die gesamte Nyquistbandbreite, die im Vergleich mit einer Anordnung mit nur einem Zweig doppelt so groß ist. T(z) besteht aus der Ausgangsfunktion H(z) und einer Verzögerung (Term $z^{-1}$). Die Amplitidenübertragung ist um einen Faktor 2 höher im Vergleich zu einem einzelnen Zweig. Gegebenenfalls sind jedoch noch die in den beiden Zweigen bei praktischen Realisierungen vorhandenen Quantisierer (A/D-Wandler) und sonstige Rauschterme zu berücksichtigen.

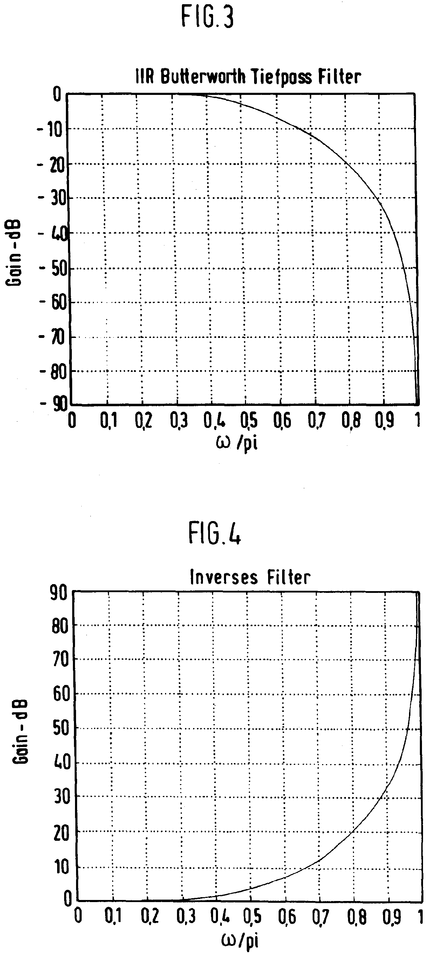

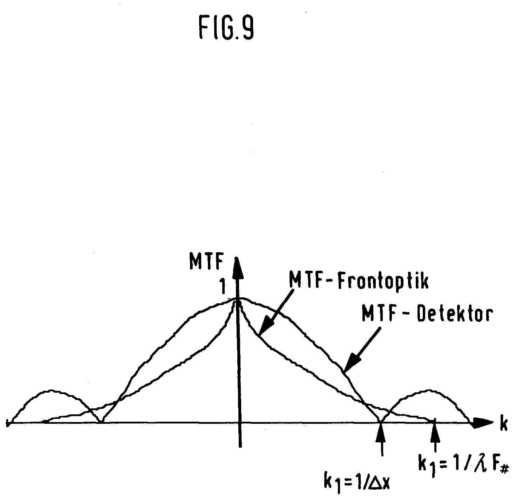

Es sollen nun im folgenden auch zu den Analysefiltern 5 inverse Synthesefilter 16 in den Zweigen 3, 4 betrachtet werden, die jeweils durch Fensterfilter 11 begrenzt und damit stabilisiert werden. Die Figuren 3 bis 7 zeigen eine bevorzugte Ausgestaltung der Filter 5, 11, 16. Es ist dabei jeweils das Analysefilter 5 als Tiefpaßfilter ausgebildet. Überträgt man die Filterbank-Struktur nach Fig. 1 auf das Signalverarbeitungsschema der Anordnung nach Fig. 8, so ergibt sich automatisch, dass die optische Abtastanordnung 14 mit den Detektoreinrichtungen 15, 17, die als Analysefilter 5 wirkt, einen Tiefpaßcharakter aufweist. Dies ist zur Verdeutlichung in Fig. 9 dargestellt, die das Übertragungsverhalten der Detektoreinrichtungen sowie einer den Detektoreinrichtungen 15, 17 vorgeschaltete Frontoptik 15,17 der optischen Abtastanordnung darstellen. Somit müssen die Synthesefilter 16 F(z) jeweils komplementäre Hochpass-Filter werden. Die hinreichende Bedingung für Aliasingfreiheit kann weiterhin erfüllt werden, wie weiterhin gezeigt wird.

Durch die Wahl der Synthesefilter 16 F(z) kann (gegenüber dem vorherigen Ausführungsbeispiel nach Fig. 1) der Übertragungscharakteristik ein anderes Verhalten gegeben werden, z.B. derart, dass im gesamten Frequenzbereich der normierten Nyquistbandbreite (0, 1) eine Verstärkung (d.h. störungsfreie Übertragung) stattfindet.

Wie bereits vorher dargestellt, stellt jedes Analysefilter 5 ein Tiefpass-Filter dar, dessen Übertragungsfunktion durch ein IIR Butterworth-Filter nachgebildet werden kann. In Fig. 3 das Übertragungsverhalten eines solchen Filters in logarithmischer Auftragung dargestellt.

Die Frequenznormierung erfolgt hier auf den Bereich kNYQ = 1 [Zyklus/ Längeneinheit]. Die Übertragungsfunktion dieses IIR-Filters ist:

$$H(z) = \frac{0{,}2929 + 0{,}5858z^{-2}}{1 + 0{,}1716z^{-2}}$$

Wählt man für F(z) ein zu H(z) inverses Filter, dann ist:

$$F(z) = \frac{1 + 0{,}1716z^{-1} + 0{,}2929^{-2}}{0{,}2929 + 0{,}5858z^{-1} + 0{,}2929z^{-2}}$$

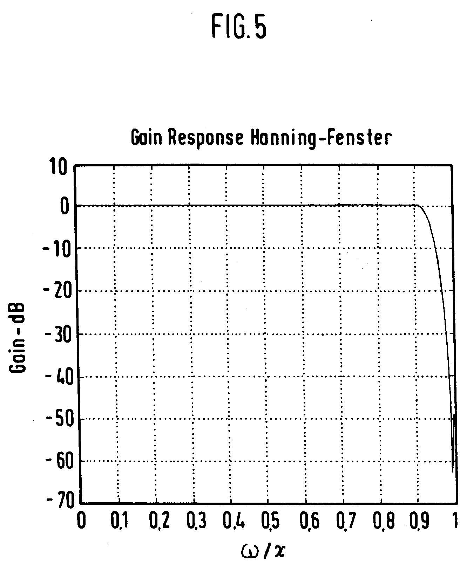

Die Inverse des Synthesefilters 16 hat den Wert "Eins" bei k=0 und "Unendlich" bei k=1. Dieses Filter ist in Fig. 4 in logarithmischer Auftragung dargestellt. Das inverse Synthesefilter 16 wäre instabil, da es das Rauschen insbesondere bei hohen Frequenzen verstärken würde. Um es stabil zu machen, kann es bei den hohen Frequenzen durch ein sog. Tiefpass-Fensterfilter 11 begrenzt werden. Dessen Übertagungsverhalten ist in Fig. 5 logarithmisch dargestellt. Die bekanntesten dieser Fensterfilter sind die FIR-Filter nach "Hamming, Hann, Bartlett, Kaiser" u.a., die aus dem Stand der Technik hinreichend bekannt sind.

In der Darstellung nach Fig. 5 wurde ein Hann-Fenster mit einer 3-dB-Eckfrequenz bei k=0,95 ausgewählt. Die Simulation zeigt, dass das FIR-Fenster mindestens von der Ordnung 40 und größer gewählt werden muss, damit der Abfall bei der oberen Eckfrequenz ausreichend scharfkantig verläuft.

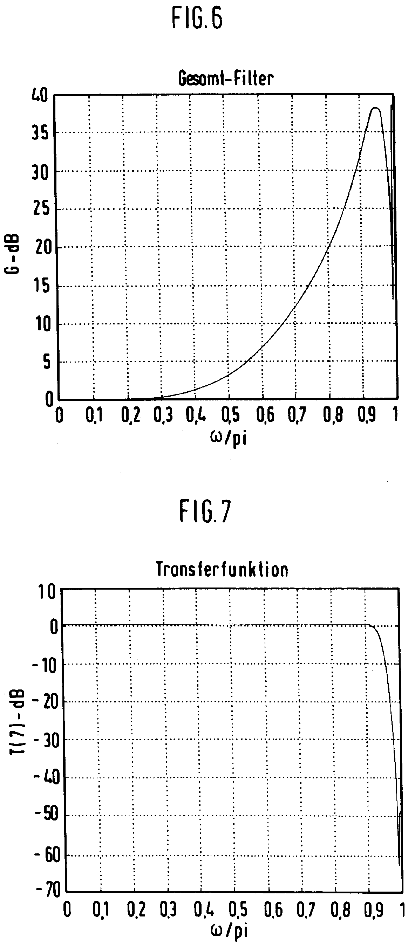

Fig. 6 zeigt das Produkt aus dem inversen Synthesefilter 16 und dem Fensterfilter 11, ebenfalls in logarithmischer Darstellung. Die gesamte Transferfunktion ergibt sich letztlich durch das weitere Produkt mit dem Übertragungsverhalten des Analysefilters 5 und man erhält den in Fig. 7 logarithmisch dargestellten Verlauf.

Der Gewinn der Filterbank mit den Synthesefiltern 16 liegt darin, dass das Tiefpaß-Übertragungsverhalten der Analysefilter 5 kompensiert wird und im Nyquistband alle Raumfrequenzen, bis zur Grenzfrequenz des FIR-Fensterfilters, gleichmäßig übertragen werden, wie Fig. 7 zeigt.

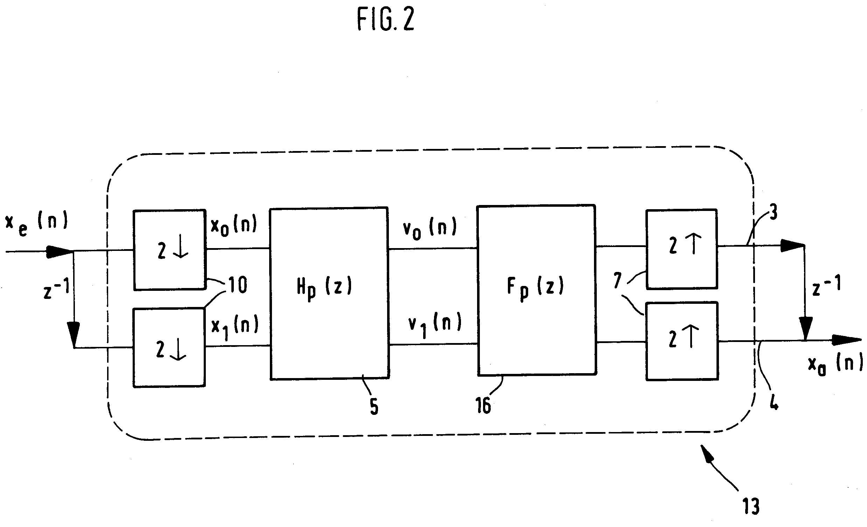

Das anhand von Fig. 1 erläuterte Signalverarbeitungsschema beruht auf einer sog. QMF-Filterbank (Quadrature Mirror Filter Bank). Fig. 2 zeigt eine weitere Lösungsvariante, die als Polyphasen-Anordnung bezeichnet wird. Der Vorteil besteht darin, dass mit diskreten Filterkomponenten 5, 16 der halben Länge die gleiche Filterung durchgeführt werden kann wie bei einer Anordnung nach Fig. 1. Das Grundprinzip werde kurz erläutert:

Wenn ein Signal in vektorieller Form zweifach abwärts gesampled wird, dann gehen die ungeraden Komponenten verloren und die geraden bleiben erhalten, oder umgekehrt. Bei der Anordnung nach Fig. 1 wird das Abwärtssampling ( $\downarrow$2 H x )nach der Filterung durchgeführt, was weniger effizient ist, da zunächst H x berechnet wird und dann nur noch die geraden Anteile übrigbleiben. Ähnlich verhält es sich mit dem Aufwärts-Sampling. Dabei ist es vorteilhafter, die Filterung vor dem ($\uparrow$2)-Operator durchzuführen und dann erst durch das zweifache Aufwärtssampling ($\uparrow$2) in den Einrichtungen 7 die Vektorlängen des Signals zu verdoppeln.

Bei der Polyphasen-Realisierung werden "gerade" - und "ungerade" Komponenten getrennt verarbeitet ( "gerade" und "ungerade" sind die beiden Phasen). Der Eingangsvektor x wird in Xeven und Xodd aufgespaltet, also x = (Xeven Xodd).

Im Z-Bereich ist der gerade Teil

$$X_{even}(z) = 1/2\,[X(z) + X(-z)\,]$$

und der ungerade Teil

$$X_{odd}(z) = 1/2\,[\,X(z) - X(-z)\,]$$

Der gerade Teil enthält ausschließlich gerade Potenzen in z, d.h. $z^2$, $z^4$ der ungerade Teil ungerade Potenzen in z, d.h. $z^1$, $z^3$, $z^5$,.... Daher ist

$$X(z) "\; X_{even}(z^2) + z^{-1}\, X_{odd}(z^2)$$

Ebenso kann ein Filter in einen geraden und einen ungeraden Teil aufgeteilt und damit dargestellt werden, als:

$$H(z) = H_{even}(z^2) + z^{-1} H_{odd}(z^2)$$

Es kann gezeigt werden, dass dadurch eine Filterbankstruktur erzeugt werden kann, bei der in der Analyse-Bank das Abwärtssampling vor dem Analyse-Filter $H_p(z)$ und in der Synthese-Bank das Aufwärtssampling nach dem SyntheseFilter $F_p(z)$ erfolgt.

Die Polyphasen-Realisierung ist in der Regel einfacher und auch effektiver, da die Filter $H_p$ und $F_p$ nebeneinander liegen. $H_p$ und $F_p$ können durch lineare zeitinvariante Filter realisiert werden. Das Abwärts- und Aufwärtssampling wird so durchgeführt, dass die Filter gegenüber der direkten Realisierung nurmehr die halbe Länge haben.

Wenn $H_p$ und $F_p$ zueinander inverse Filterungs-Matrizen sind, dann erhält man perfekte Rekonstruktion, d. h. es gilt:

$$F_p(z) \cdot H_p(z) = |, \text{oder } z^{-1}$$

wobei | die Einheitsmatrix darstellt.

Wie bereits ausgeführt, kann die erfindungsgemäße Filterbank bei optischen Abtastanordnungen Anwendung finden. Optoelektronisch abtastende Bildaufnahmesysteme (Scanner, digitale Kameras, etc.) beruhen auf dem Prinzip einer räumlich diskreten Abtastung der in die Fokalebene abgebildeten Bildszene. Die Abtastung erfolgt durch lichtempfindliche Detektoren mit endlich gro-ßer Empfangsfläche. Im vorliegenden Fall wird eine ideal angepasste optimale Signalverarbeitung bereitgestellt.

Bei Einsatz einer einzelnen Detektorzeile oder einer einzelnen Detektormatrix zur Bildabtastung in der Fokalebene erfolgt eine Unterabtastung, da - wie einfach gezeigt werden kann - das Shannon'sche Abtasttheorem verletzt wird. Als Folge davon sind im Abtastsignal störende Aliasfrequenzen enthalten, die bei der Bildwiedergabe durch sogenannte Moiré-Effekte sichtbar werden. Um dies zu vermeiden, muss eine ausreichende Abtastung sichergestellt werden.

Die Auflösungsgrenzen der Bildaufnahmesysteme sind durch Aperturdurchmesser und Brennweite der Frontoptik und ebenso durch den diskreten Abtastprozess mit den eingesetzten Detektor-Arrays (diskrete Zeilen- oder Matrizen-Anordnungen) festgelegt. Ein Signal (hier die Bildszene) kann theoretisch von seinen Abtastwerten wieder rekonstruiert werden, wenn bestimmte Bedingungen hinsichtlich des Signalspektrums und der Abtastrate eingehalten werden. (Shannon'-sches Abtasttheorem). Signalanteile oberhalb der halben Abtastfrequenz (Nyquistfrequenz) können nicht mehr rekonstruiert werden, und eine Rückfaltung der bei der Abtastung entstehenden Alias-Spektren in das Basisband erfolgt, wenn das abzutastende Signal nicht auf die Nyquistbandbreite begrenzt wird.

Wie sich zeigen lässt, wird bei fast allen optischen Bildaufnahmesystemen das optische Signal vor der Abtastung nicht ausreichend bandbegrenzt und damit die Abtastbedingung verletzt. Das rekonstruierte Signal (die Bilddaten) enthält in diesen Fällen den entstehenden Aliasing-Spektren zuzuordnende Störungen. Dieser Effekt ist aus der Fernsehtechnik lange bekannt; er wirkt sich vor allem störend aus, wenn die Bilddaten eine hohe Wiedergabetreue erfüllen müssen, wie z.B. in der Medizintechnik, wo Bildaufnahmesysteme als Diagnosesysteme eingesetzt sind und durch die Bildaufnahmetechnik generierte Artefakte zu verkehrten Diagnosen führen können. Ähnliche Anforderungen müssen auf dem Gebiet der Kriminalistik und Beweissicherungstechnik gefordert werden.

Weite Anwendung finden optische Bildaufnahmesystem in der Beobachtung und Aufklärung durch luftgestützte - oder satellitengestütze Systeme. Hierbei werden die generierten Bilddaten häufig automatisch weiterverarbeitet, wie z.B. bei Kartografie, der Errechnung von topographischen Höhenmodellen aus Stereobildern. Bildverfälschungen erschweren die automatische Anwendbarkeit der Verarbeitungsalgorithmen, so dass Maßnahmen dagegen ergriffen werden müssen.

Die Realiserung nicht-unterabtastender und damit aliasingfreier Systeme ist ein Gegenstand dieser Erfindung. Als einfachste Realisierung erscheint die Anordnung einer "Bilinearen Zeile" nach Fig. 8, d.h. der Anordnung von zwei parallelen Detektorzeilen 15, 17 mit einem gegenseitigen Versatz der Detektoreinrichtungen 15, 17, mit der die Abtastrate gegenüber den üblicherweise eingesetzten einfachen Detektorzeilen verdoppelt wird.

Solche Anordnungen sind grundsätzlich in der Literatur beschrieben. Gegenstand der vorliegenden Erfindung ist jedoch die Ausbildung einer solchen Anordnung als Teil einer erfindungsgemäßen Filterbank-Anordnung.

Das Grundprinzip der Erhöhung der Abtastrate kann ebenso auf mehrfache Abtastanordnungen erweitert werden, z.B. auf die Abtastung durch M-parallele Detektorzeilen und der Signalverarbeitung in einer M-fachen Filterbank. Gleichermaßen sind zweidimensionale Abtastanordnungen, wie mit parallelen optischen Instrumenten oder durch parallele Anordnungen von Flächendetektoren (Detektor-2D-Arrays) mit entsprechend für die Signalverarbeitung nachgeschaltenden höherdimensionalen Filterbänken, möglich.

M parallele Detektorzeilen, die jeweils einen Versatz, z.B. von einem M-tel der Breite des Einzeldetektors (Pixels) gegeneinander haben, stellen eine verbesserte Anordnung dar, da durch die parallele Abtastung die Abtastrate in der räumlichen Zeilenrichtung erhöht wird, wenn die einzelnen Signale der Zeilendetektoren zeitsynchron ineinander zu einem Signal verschachtelt werden. Die Abtastung in der zweiten Richtung erfolgt über eine orthogonale Abtastbewegung der Detektorzeilen über das Bildfeld, wobei eine M-fache Abtastung (Oversampling) über dem Auflösungselement erfolgt. Beide Maßnahmen zusammen bewirken somit die M-fache Erhöhung der Abtastrate.

Da die Unterabtastung bei Schwarz-Weiss-Bildaufnahmesystemen in der Regel zweifach ist, stellt eine bewegte bilineare Detektorzeile (d.h. mit M=2 parallelen Detektorzeilen) die einfachste und aufwandseffizienteste Abtastanordnung dar. Bei Farbbildaufnahmesystemen gelten die gleichen Prinzipien pro Farbkanal und es wird je eine bilineare Detektorzeile pro Farbkanal benötigt.

Es wird also der Grundgedanke verfolgt, mit der Anordnung einer "bilinearen Zeile" die Unterabtastung zu beheben und ein aliasingfreies Abtastsystem zu ezeugen, damit eine verbesserte Raumfrequenzauflösung erzielt wird. Der Aufbau der optischen Abtastanordnung 14 besteht aus 2 parallelen Detektorzeilen 15, 17, wobei die benachbarten Pixel zwischen den Zeilen einen gegenseitigen Versatz einer halben Pixelbreite aufweisen. Die räumlich Abtastung erfolgt entlang der Längserstreckung der Detektorzeilen 15, 17. Senkrecht dazu erfolgt eine Bewegung der Abtastanordnung 14, so dass in dieser Raumrichtung eine zugleich räumliche und zeitliche Abtastung erfolgt.

Durch Kombination der Detektorsignale der einzelnen Detektorzeilen 15, 17, wie vorstehend für die erfindungsgemäße Filterbank-Anordnung beschrieben, wird eine Verdopplung der räumlichen Abtastung erzeugt. In der zweiten Abtastrichtung senkrecht zur Längserstreckung der Detektorzeilen 15, 17 (in Bewegungsrichtung der Abtastanordnung) kann durch Überabtastung (oversampling) gleichermaßen eine Verdopplung der Sampling-Raumfrequenz erzeugt werden, so dass insgesamt in beiden Richtungen die Unterabtastung behoben wird.

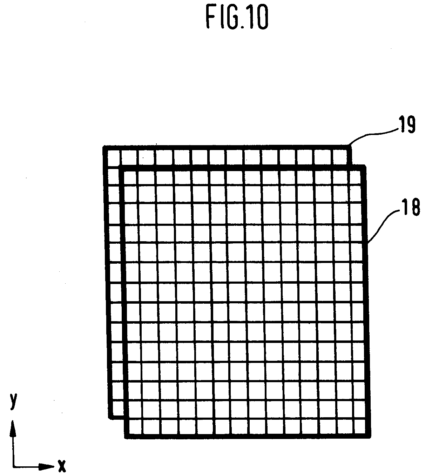

Fig. 10 zeigt eine schematische Darstellung einer Detektoranordnung aus zwei Detektormatrizen 18, 19, die um eine halbe Pixelbreite in jede Raumrichtung x, y der Ebene, in der sich die Detektormatritzen 18, 19 erstrecken, gegeneinander versetzt sind. Mit einer solchen Anordnung kann eine direkte, simultane zweidimensionale Abtastung erfolgen. Die gesamte Filterbank-Anordnung ist dann so auszulegen, daß eine simultane, zweidimensionale Filterung erfolgt.

In der hier konzipierten Anordnung stellen also die parallelen Detektorzeilen bereits den Analyseteil dar, denn jede Detektorzeile liefert ein zeitdiskretes analoges Signal, das aus der Folge der einzelnen Detektorsignale besteht. Nach Analog-Digitalwandlung können die digitalisierten Zeilensignale in einen nachgeschalteten Syntheseteil eingespeist und verarbeitet werden. In den Signalpfaden des Analyseteils entspricht die sogenannte Blurfunktion des optischen Abbildungssystems einem Analysefilter.

Wie beschrieben kann das Übertragungsverhalten des abtastenden Bildaufnahmesystems durch den Synthesezweig so gestaltet werden, dass sich für die gesamte Anordnung, die einer Filterbank entspricht, ein nahezu optimales Übertragungsverhalten ergibt. Aliasingfreiheit kann bereits durch das Zusammenführen mehrerer Zeilensignale erreicht werden. Führt man die zusätzliche Filterung im Syntheseteil ein, dann kann eine praktisch perfekte Übertragung erzielt werden, wenn die Synthesefilter als inverse Filter zur Blurfunktion des Analysezweiges gewählt werden. Eine solche Signalprozessierung kann als optimal angesehen werden, da in einem solchen Fall ein Eingangssignal praktisch ungestört übertragen wird.

Wesentliche Vorteile des vorliegenden Konzeptes der bilinearen Detektor-Konzeption sind daher:

- aliasingfreies Aufnahmesystem,

- Verdopplung der Nyquistfrequenz durch doppelte räumliche und zeitliche Abtastung und daher Verdopplung der Raumfrequenz-Auflösung,

- Bild-Aufnahmecharakteristik (Übertragungsfunktion) mit hoher Wiedergabetreue, da die Tiefpasscharakteristik der sogenannten Blurfunktion durch die invese Filterung weitgehend egalisiert wird und alle Raumfrequenzanteile mit praktisch gleicher Amplitude übertragen werden,

- Aufwandsoptimale Realisierung des Syntheseteils, insbesondere dann, wenn diese in Form einer Polyphasen-Struktur erfolgt.

**Patentansprüche**

1. Filterbank-Anordnung, beinhaltend eine Analysebank (1) und eine Synthesebank (2),

- wobei sich der Signalpfad durch die Filterbank im Bereich der Analysebank (1) auf mindestens zwei Zweige (3, 4) aufteilt und im Bereich der Synthesebank (2) die Zweige (3, 4) wieder zusammengeführt werden, und

- jeder der Zweige (3, 4) identische Analysefilter (5) aufweist und die Synthesebank (2) eine Kombiniereinrichtung (6) zur Kombination der Signale der einzelnen Zweige (3, 4) aufweist,

**dadurch gekennzeichnet,** daß die Zweige (3, 4) Einrichtungen (7) zum Aufwärtssampling sowie Verzögerungseinrichtungen (8, 9) zur relativen Verzögerung der Signale der einzelnen Zweige (3, 4) untereinander aufweisen.

2. Filterbank-Anordnung nach Anspruch 1, **dadurch gekennzeichnet,** daß die Zweige (3, 4) zusätzlich Einrichtungen (10) zum Abwärtssampling aufweisen, die den Einrichtungen (7) zum Aufwärtssampling vorgeschaltet sind.

3. Filterbank-Anordnung nach einem der Ansprüche 1 bis 2, **dadurch gekennzeichnet,** daß die Analysefilter (5) als Tiefpaß-Filter ausgebildet sind.

4. Filterbank-Anordnung nach einem der Ansprüche 1 bis 3, **dadurch gekennzeichnet,** daß jedes der Analysefilter (5) mit einem entsprechenden inversen Filter (16) kombiniert ist.

5. Filterbank-Anordnung nach Anspruch 4, **dadurch gekennzeichnet,** daß ein Fensterfilter (11) zur Begrenzung des inversen Filters (16) vorgesehen ist.

6. Filterbank-Anordnung nach einem der Ansprüche 1 bis 5, **dadurch gekennzeichnet,** daß die Filterbank-Anordnung als Polyphasen-Anordnung (13) ausgebildet ist.

7. Filterbank-Anordnung nach einem der Ansprüche 1 bis 6, **dadurch gekennzeichnet,** daß die Filterbank-Anordnung eine optische Abtastanordnung (14) beinhaltet.

8. Optische Abtastanordnung (14), die mindestens zwei Detektoreinrichtungen (15, 17) aufweist, **dadurch gekennzeichnet,** daß

- jeder Detektoreinrichtung (15, 17) mindestens ein Zweig (3, 4) einer Filterbank-Anordnung zugeordnet ist und jede Detektoreinrichtung (15, 17) einen Analysezweig der Filterbank-Anordnung bildet,

- die Filterbank-Anordnung eine Synthesebank (2) aufweist, wobei sich der Signalpfad durch die Filterbank auf mindestens zwei Zweige (3, 4) aufteilt und im Bereich der Synthesebank (2) die Zweige (3, 4) wieder zusammengeführt werden,

- die Synthesebank (2) eine Kombiniereinrichtung (6) zur Kombination der Signale der einzelnen Zweige (3, 4) aufweist, und

- die Zweige (3, 4) Einrichtungen (7) zum Aufwärtssampling sowie Verzögerungseinrichtungen (8, 9) zur relativen Verzögerung der Signale der einzelnen Zweige (3, 4) untereinander aufweisen.

9. Optische Abtastanordnung nach Anspruch 8, **dadurch gekennzeichnet,** daß jede Detektoreinrichtung (15, 17) als Tiefpassfiler mit einem nachfolgenden Abwärtssampler wirkt.

10. Optische Abtastanordnung nach Anspruch 8 oder 9, **dadurch gekennzeichnet,** daß jede Detektoreinrichtung (15, 17) zeilenförmig ausgebildet ist.

11. Optische Abtastanordnung nach Anspruch 10, **dadurch gekennzeichnet,** daß die zeilenförmigen Detektoreinrichtungen (15, 17) parallel zueinander und in einer Raumrichtung gegeneinander versetzt angeordnet sind.

12. Optische Abtastanordnung nach Anspruch 8 oder 9, **dadurch gekennzeichnet,** daß jede Detektoreinrichtung (15, 17) matrixförmig ausgebildet ist.

13. Optische Abtastanordnung nach Anspruch 12, **dadurch gekennzeichnet,** daß jeder Zeile oder Spalte der Detektoreinrichtung (15, 17) ein Zweig der Filterbank-Anordnung zugeordnet ist.

14. Optische Abtastanordnung nach Anspruch 13, **dadurch gekennzeichnet,** daß die optische Abtastanordnung zwei matrixförmige Detektoreinrichtungen (15, 17) aufweist, die in beide Raumrichtung der Ebene, in der sich die Detektoreinrichtungen (15, 17) erstrecken, gegeneinander versetzt sind.

15. Optische Abtastanordnung nach einem der Ansprüche 8 bis 14, **dadurch gekennzeichnet,** daß jede als Analysezweig wirkende Detektoreinrichtung (15, 17) mit einem entsprechenden inversen Filter (16) kombiniert ist.

16. Optische Abtastanordnung nach Anspruch 17, **dadurch gekennzeichnet,** daß ein Fensterfilter (11) zur Begrenzung des inversen Filters (16) vorgesehen ist.

17. Optische Abtastanordnung nach einem der Ansprüche 8 bis 16, **dadurch gekennzeichnet,** daß die Filterbank-Anordnung als Polyphasen-Anordnung (13) ausgebildet ist.

18. Anordnung nach einem der Ansprüche 1 bis 17, **dadurch gekennzeichnet,** daß die Filterbank-Anordnung zur simultanen zweidimensionalen Filterung ausgebildet ist.

# FIG.1

EP 1 102 396 A2

# FIG. 2

EP 1 102 396 A2

## FIG.3

**IIR Butterworth Tiefpass Filter**

## FIG.4

**Inverses Filter**

# FIG.5

Gain Response Hanning-Fenster

EP 1 102 396 A2

## FIG. 6

### Gesamt-Filter

## FIG. 7

### Transferfunktion

15

# FIG. 8

EP 1 102 396 A2

Y

Bewegungsrichtung

und zeitlich/räumliche Abtastrichtung

14

Active Pixel Electronics and Readout Register

Tap 1

15

5800 Pixel

5800 Pixel

Active Pixel Electronics and Readout Register

Tap 2

17

MUX

X

räumliche Abtastrichtung

# FIG.9

# FIG.10